# FASCICULE DE BREVET EUROPEEN

(11) **EP 1 824 779 B1**
(45) Date de publication et mention de la délivrance du brevet: **05.11.2008**
(21) Numéro de dépôt: 05824668.7
(22) Date de dépôt: 13.12.2005
(51) Int. Cl.: B81C 3/00, H01L 23/28

(54) **DISPOSITIF ET PROCEDE DE FERMETURE HERMETIQUE D'UNE CAVITE D'UN COMPOSE ELECTRONIQUE**
VORRICHTUNG UND VERFAHREN ZUR HERMETISCHEN ABDICHTUNG EINES HOHLRAUMS IN EINEM ELEKTRONISCHEN BAUTEIL
DEVICE AND METHOD FOR HERMETICALLY SEALING A CAVITY IN AN ELECTRONIC COMPONENT

(30) Priorité: 15.12.2004 FR 0452994
(43) Date de publication de la demande: 29.08.2007
(73) Titulaire: COMMISSARIAT A L'ENERGIE ATOMIQUE, 75015 Paris (FR); CENTRE NATIONAL D'ETUDES SPATIALES, F-75001 Paris (FR)
(72) Inventeur: LAI, Aymeric, F-38000 Grenoble (FR)
(74) Mandataire: Poulin, Gérard
(86) Numéro de dépôt international: PCT/FR2005/051077
(87) Numéro de publication internationale: WO 2006/064158

(56) Documents cités:
- US-A1- 2001 055 831
- US-A1- 2003 111 441
- PATENT ABSTRACTS OF JAPAN vol. 2002, no. 11, 6 novembre 2002 (2002-11-06) -& JP 2002 190548 A (HITACHI CABLE LTD), 5 juillet 2002 (2002-07-05)

## Description

### DOMAINE TECHNIQUE

L'invention se rapporte aux composants dans lesquels une cavité, notamment étanche, est présente. Plus particulièrement, l'invention concerne la fermeture hermétique après remplissage et/ou mise sous vide d'une cavité dans un composé microélectronique.

Sous un aspect, l'invention concerne un procédé de fermeture par coulissement d'un dispositif permettant de boucher hermétiquement une cavité, ainsi que des moyens de fermeture permettant une telle obturation.

Grâce au procédé et au dispositif selon l'invention, la mise sous vide et/ou le remplissage de la cavité peuvent être effectués par l'intermédiaire du même dispositif que la fermeture.

### ÉTAT DE LA TECHNIQUE ANTÉRIEURE

Certains composés microélectroniques comprennent des cavités, permettant par exemple la protection de composants. Les cavités sont alors soit mises sous vide, soit remplies de fluide, mais, quoi qu'il en soit, dans de nombreuses applications, les cavités doivent ensuite demeurer hermétiques et leur milieu contrôlé.

La solution la plus communément adoptée à cette fin est, jusqu'à présent, l'utilisation d'un conduit de remplissage aménagé lors de la fabrication du composé. Ce conduit peut être réalisé en même temps et dans le même matériau que l'enveloppe de la cavité à remplir, ou fixé (par exemple collé ou brasé) sur un trou réalisé dans le matériau qui enveloppe la cavité. Une fois la cavité mise sous vide et remplie de fluide par l'intermédiaire du conduit, ce dernier est pincé ou fondu, ou un couvercle lui est soudé, afin d'obtenir un queusot hermétique.

Une autre solution pour le remplissage de caloducs a été décrite par Kang S-W et coll. (« Fabrication and test of radial grooved micro heat pipes », Applied Thermal Engineering 2002 ; 22 : 1559-68). Un dispositif d'encapsulation en silicone est utilisé, qui comprend deux cavités : l'une des cavités, ouverte, est reliée à une pompe à vide, et l'autre, surmontée d'une fine membrane, est amenée à jouer le rôle d'une cloison que l'on peut percer tout en la maintenant étanche (ou « septum ») pour le remplissage. Initialement, la cavité liée à la pompe est placée au dessus du trou de remplissage du caloduc ; une fois le vide recherché atteint, le dispositif est déplacé pour obturer le trou et la seconde cavité est placée en regard du trou de remplissage, afin d'introduire alors le liquide à l'aide d'une seringue.

Si un tel dispositif permet de conserver la cavité scellée entre la mise sous vide et le remplissage, le problème de la fermeture de la cavité du dispositif, en l'occurrence du caloduc, n'est pas abordé : en particulier, comme le liquide de remplissage est de l'eau, il est possible d'utiliser les couvercles d'encapsulation classiques.

Cependant, cette solution, comme les autres décrites dans l'état de la technique, est problématique dans le cas où une grande compacité ou un encombrement minimal du système sont nécessaires, du fait du volume du queusot : en effet, la réalisation de la fermeture hermétique entraîne la formation d'une protubérance de l'enveloppe inhérente au scellement. En particulier, l'enveloppe obtenue n'est pas plane.

Le document US-A-2003/111441 divulgue un procédé d'encapsulation miniature d'un composé microélectronique dont le substrat d'armature est réalisé en céramique, métal ou un alliage des deux et qui comprend une entretoise prévue pour délimiter une cavité. L'encapsulation comprend également une matrice comportant un substrat, un microcomposant sur le substrat, des plots de connexion intégrés sur le substrat, et des conducteurs électriques intégrés dans le substrat pour relier électriquement les plots de connexion au microcomposant. La matrice est montée sur l'entretoise pour former une cavité dans laquelle est logé le microcomposant et en dehors de laquelle les plots de connexion sont situés.

Le document JP-A-2002/190548 divulgue un procédé de fabrication d'un composé semi-conducteur selon la technique « *flip-chip* », avec la création d'un trou entre deux plaques externes de façon à définir une cavité.

Le document US-A-2001/055831 divulgue un procédé de fabrication d'un dispositif microélectronique comprenant une couche avec fomation d'un ou plusieurs vias à travers. Une couche sacrificielle est alors partiellement gravée pour former un ou plusieurs évidements aux endroits correspondant aux emplacements des vias dans la couche. Les vias et les évidements sont alors remplis pour former une structure ayant un ou plusieurs bouchons dépassant de la couche de dispositif. La couche sacrificielle est enfin enlevée pour libérer le dispositif.

### EXPOSÉ DE L'INVENTION

L'invention se propose de pallier les inconvénients mentionnés et de permettre une fermeture d'une cavité d'un composé microélectronique entraînant un encombrement minimal.

Sous l'un de ses aspects, l'invention concerne un procédé de fermeture de la cavité d'un composé microélectronique grâce à un bouchon dont une partie au moins est susceptible d'être déformée plastiquement.

De façon préférée, la déformation plastique est une fusion d'une partie du bouchon composée de matériau fusible, et avantageusement localisée autour d'une partie en matériau inerte du bouchon. De préférence, la partie en matériau inerte du bouchon est de même composition que le matériau de la surface du composé électronique. Il est en outre possible de revêtir en surface, autour de l'orifice à obturer, le composé de matériau fusible également.

Un autre mode de réalisation concerne un bouchon en métal mou qui est déformé plastiquement par l'application d'une pression.

Le bouchon est de préférence intégré à une surface d'un dispositif de fermeture qui peut coulisser sur la surface du composé comprenant l'orifice menant à la cavité à sceller ; en particulier, le bouchon est logé dans une première cavité du dispositif de fermeture. Lors du procédé de fermeture, le dispositif, qui comprend avantageusement une deuxième cavité permettant la mise sous vide et/ou le remplissage par l'orifice, est déplacé sur la surface de manière à mettre le bouchon en regard de l'orifice du composé. Une déformation plastique du bouchon permet alors la fermeture étanche.

A des fins d'herméticité, il est préférable que de la graisse soit placée à l'interface entre les deux surfaces coulissantes. Le guidage en coulissement peut être assuré par l'intermédiaire de rainures ou de butées présentes sur le dispositif et/ou autour du trou afin de permettre un alignement par exemple.

Grâce au procédé selon l'invention, il est possible de dimensionner le bouchon et l'orifice de façon à ce que, une fois la déformation plastique effectuée, le bouchon ne dépasse pas de la surface du composé.

Sous un autre aspect, l'invention se rapporte à un dispositif de fermeture permettant de mettre en oeuvre le procédé précédent. En particulier, un tel dispositif peut être associé à un composé électronique comprenant une cavité de façon à permettre sa fermeture hermétique. Le dispositif selon l'invention comprend un bouchon qui peut être déformé plastiquement pour obturer un orifice. Le dispositif peut comprendre une ou des cavités, qui peuvent éventuellement communiquer avec l'environnement du bouchon, associées à des moyens de remplissage et/ou de mise sous vide.

L'invention se rapporte aussi à un bouchon qui peut être utilisé dans le dispositif ou avec le procédé précédents.

### BRÈVE DESCRIPTION DES DESSINS

Les caractéristiques et avantages de l'invention seront mieux compris à la lecture de la description qui va suivre et en référence aux dessins annexés, donnés à titre illustratif et nullement limitatifs.
La figure 1 représente un dispositif microélectronique dont la cavité a été bouchée par un procédé selon l'invention.
La figure 2 montre une alternative de fermeture selon l'invention.
Les figures 3A-3C montrent schématiquement le remplissage et la fermeture d'une cavité selon un mode préféré de l'invention.
La figure 4 illustre un autre procédé de fermeture.
Les figures 5A et 5B représentent une alternative pour la déformation plastique du bouchon.

### EXPOSÉ DÉTAILLÉ DE MODES DE RÉALISATION PARTICULIERS

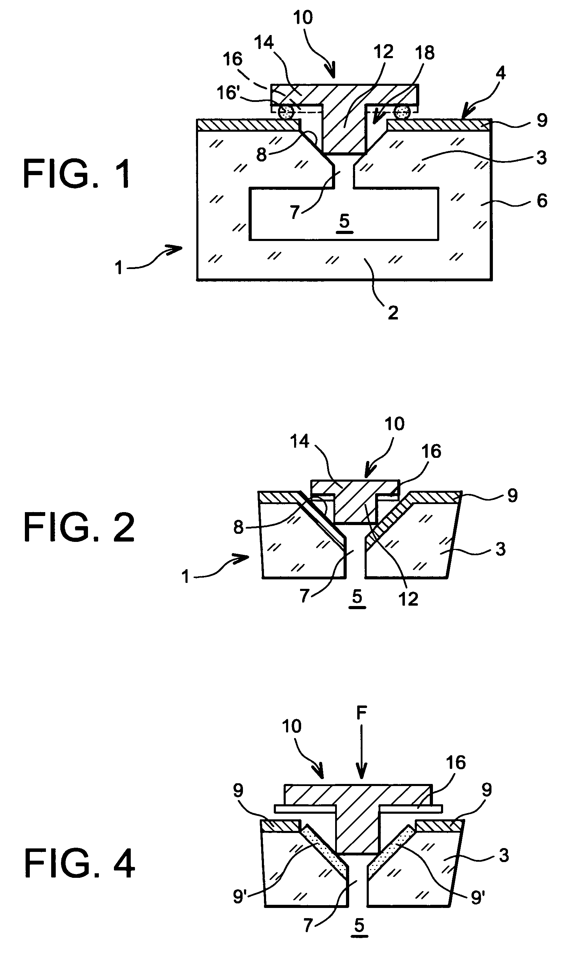

Les micro dispositifs électroniques, tel que schématisé sur la figure 1, sont particulièrement concernés par la fermeture selon l'invention. Un composé microélectronique 1, d'épaisseur de l'ordre du mm pour une surface de l'ordre du cm², comprend ainsi de façon générale un substrat 2 et une couche supérieure 3, éventuellement de même nature ; la plupart du temps, la surface externe 4 de la couche supérieure 3 est plane. Dans le composé 1 est localisée une cavité 5 délimitée par le substrat 2, la couche supérieure 3, et des parois latérales 6, dont la hauteur dépend de l'usage qui en est fait ; habituellement, la cavité 5 se trouve dans un composé 1 en silicium. La cavité 5 débouche dans la surface externe 4 du composé 1 par un orifice 7. De préférence, l'orifice 7 est de taille minime au niveau de la cavité, par exemple compris dans un cercle de diamètre entre 100 µm et 1 mm ; l'orifice 7 peut cependant comprendre une embouchure évasée 8 au niveau de la surface externe 4 du composé 1, qui est généralement une couche 9 de métal.

Selon l'invention, la cavité 5 est fermée hermétiquement par l'intermédiaire d'un bouchon 10 placé au niveau de l'orifice 7. Dans un premier mode de réalisation, le bouchon 10 a une forme de champignon dont le pied 12 est si possible de taille à pénétrer dans le trou 7, 8. Avantageusement, le pied 12 est de taille supérieure à celle de l'orifice 7 au niveau de la cavité 5 et inférieure à la surface de l'embouchure 8 au niveau de la face externe 4 du composé 1 : le bouchon 10 peut donc être au moins partiellement localisé dans l'embouchure 8 et boucher l'orifice 7. La hauteur du bouchon 10 est la plus petite possible, par exemple de l'ordre de quelques centaines de microns, en particulier entre 100 µm et 1 mm.

Dans ce mode de réalisation, le bouchon 10 comprend un coeur (pied 12, couvercle 14) composé d'un matériau inerte, de préférence de nature identique à celle de la couche supérieure 3, c'est-à-dire semi-conducteur, par exemple du silicium. Par ailleurs, une face du bouchon 10 qui peut venir en contact avec la surface externe 4 du composé 1 est revêtue d'un matériau fusible 16, qui pourrait par exemple être un métal comme l'étain, ou le nickel ou l'or (en particulier pour l'adhérence), ou le plomb ou l'indium, un mélange de ces métaux, ainsi que leurs alliages. En particulier, le dessous du couvercle 14 est recouvert de ce matériau 16 (voir pointillés) qui est déformable plastiquement. Une fois le bouchon 10 mis en place, une montée en température permet la fusion du matériau 16 qui vient alors en contact avec la couche métallisée 9 et s'y solidarise (traits pleins) ; avantageusement, le métal 9 est choisi de façon appropriée, en particulier pour son adhérence (par exemple, il peut s'agir d'une couche ou d'une succession de couches en Ti/Ni/Au), mais il est possible aussi d'avoir un contact direct sur le silicium de la couche supérieure 3. La fermeture est ainsi hermétique, avec le matériau fusible 16' qui forme une enceinte étanche 18 autour entre le bouchon 10 et l'embouchure 8.

Il est par ailleurs possible de prévoir une hauteur de pied 12 et de couvercle 14 telles que le bouchon 10 est entièrement localisé dans l'embouchure 8 une fois la fusion réalisée : voir le schéma de la figure 2, dans lequel la fusion n'a pas été réalisée (le matériau fusible 16 est localisé en dessous du couvercle 14). Dans ce cas, il peut être souhaitable de métalliser également les parois de l'embouchure 8. Ainsi, la fermeture est plus compacte, et le composé 1 est plan.

Réciproquement, il est possible d'avoir un orifice 7 de dimensions importantes.

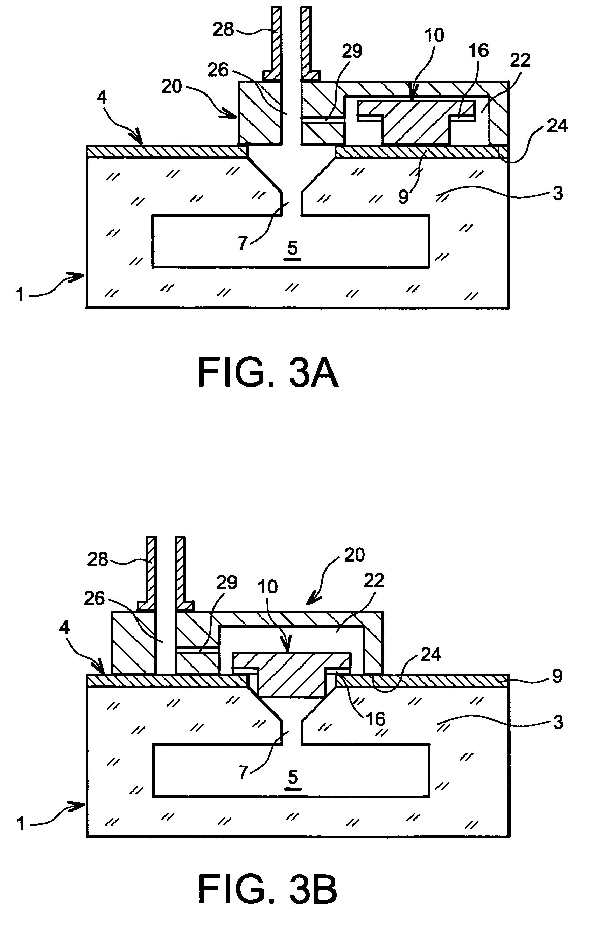

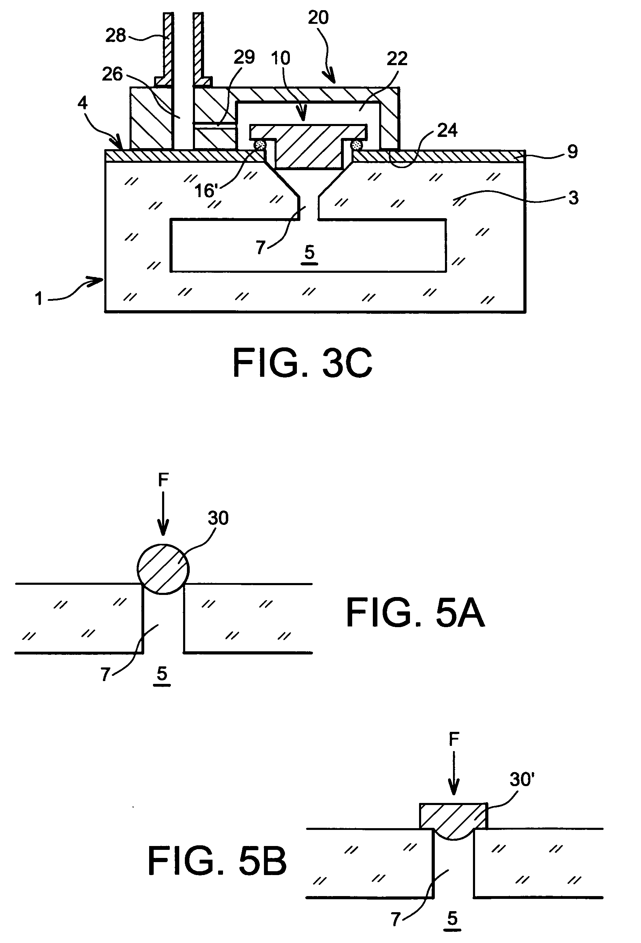

Afin de mettre en place le bouchon 10, ce dernier fait avantageusement partie d'un dispositif de fermeture 20 comme schématisé sur les figures 3 ; selon un mode de réalisation préféré, le bouchon 10 est localisé dans une première cavité 22 du dispositif 20 et adjacent à une surface de contact 24 du dispositif 20 avec le composé 1. La première cavité 22 est avantageusement de taille légèrement supérieure à la taille du couvercle 14 de sorte que le bouchon 10 « ne flotte pas » dans la cavité 22 mais est maintenu par les parois de façon relative sans y être solidarisé, c'est-à-dire que le bouchon 10 est libre de se déplacer dans une direction, vers le bas, dans la cavité 22 (de façon analogue à un tiroir). La première cavité 22 est ouverte, de sorte que le bouchon 10 « tombe » dès qu'elle est en regard d'un espace vide comme l'embouchure 8.

Le bouchon 10 peut être placé dans la cavité 22 avant que le dispositif 20 ne soit positionné sur le composé 1, ou le bouchon peut être mis en place sur la surface 4 du composé, de façon relativement éloignée de l'embouchure 8, puis le dispositif 20 est positionné de façon à ce que le bouchon 10 soit placé dans la cavité 22.

Par ailleurs, afin d'assurer la mise sous vide et le remplissage de la cavité 5 par le même dispositif 20 que la fermeture, il peut être avantageux que le dispositif 20 présente une deuxième cavité 26 servant aux autres opérations. Avantageusement, la deuxième cavité 26 traverse le dispositif 20 de part en part et peut être connectée, par exemple par un tuyau 28, à des moyens pour pomper et/ou remplir la cavité 5 ; de même que précédemment, la deuxième cavité 26 peut être ouverte à une ou ses deux extrémités, ou elle peut être temporairement fermée par des moyens de type membrane. Il peut être avantageux que la deuxième cavité 26 soit mise en communication avec la première cavité 22 afin d'assurer la même atmosphère entre la première cavité 22 et la cavité 5 du composé microélectronique 1, par exemple par un canal 29 tel que schématisé sur la figure 3, ou de préférence par une rainure sur la surface 24 du dispositif 20 en contact avec le composé 1. En effet, lorsque le tube 28 met sous vide la cavité 5 par exemple, il est souhaitable de procéder simultanément à la mise sous vide de la cavité 22 afin d'éviter toute contamination.

Il est possible aussi, bien que non représenté, d'utiliser un dispositif 20 comprenant par exemple une cavité pour la mise sous vide et une cavité pour le remplissage tel que décrit plus haut en relation avec l'état de l'art.

La surface de contact 24 du dispositif de fermeture 20 est amenée à glisser, dans un mouvement de translation ou de rotation, sur la surface externe 4 du composé 1. Avantageusement, la surface 24 est plane.

Lors de la phase de mise sous vide et/ou remplissage (figure 3A), les moyens permettant le remplissage et/ou la mise sous vide 26, 28 sont mis en regard de l'orifice 7 du composé 1. Le milieu de la cavité 5 est alors préparé tel que souhaité pour son utilisation ; par exemple, un pompage diminue la pression dans la cavité 5 qui est ensuite remplie par un liquide aux propriétés adéquates. Avantageusement, la même atmosphère est mise en oeuvre dans la cavité 22.

Afin de boucher la cavité 5, c'est-à-dire d'obturer l'orifice 7, comme illustré sur la figure 3B, on fait alors glisser le dispositif 20, en translation ou en rotation, sur la surface 4 de façon à mettre l'orifice 7 en contact avec le bouchon 10. Pour assurer l'herméticité lors du coulissement du dispositif 20 sur le composé 1, une graisse à vide, par exemple du type graisse au silicone ou graisse « High Vacuum », peut être utilisée entre la surface externe 4 du composé 1 et la surface inférieure 24 du dispositif 20. Le bouchon 10 pénètre partiellement dans l'embouchure 8, en raison principalement de la gravité.

Le matériau fusible 16 est alors amené à température de fusion afin de se répandre sur la couche de métallisation 9 préalablement déposée autour de l'orifice 7 de remplissage et de réaliser l'herméticité : figure 3C. La forme du bouchon 10 est de préférence telle que la matière fusible 16' ne se répand pas dans la cavité 5, par exemple la taille du pied 12 est supérieure à la taille de l'orifice 7.

Il est possible de déposer le matériau fusible 16 également autour de l'orifice 7 de remplissage afin que le matériau 16 sur le couvercle 14 et autour de l'embouchure 8 s'amalgament après chauffe.

Selon un mode de réalisation préféré, après la mise en place du bouchon 10 illustrée en figure 3B, le liquide de remplissage de la cavité 5 susceptible de s'être condensé sur la couche de métallisation 9 est évacué par un second pompage. Le bouchon 10 peut alors être maintenu en place par la pression F d'un outil : figure 4.

Un tel outil de pression peut être utilisé quoi qu'il en soit afin de limiter les fuites de liquide depuis la cavité 5 le temps du soudage du matériau fusible 16, voire pour positionner précisément le bouchon 10 dans l'embouchure 8. Un film 9' de matériau inerte par rapport au fluide injecté dans la cavité 5 et compatible pour le vide, par exemple du cuivre ou du silicone, peut dans ce cas être déposé, en périphérie de l'orifice 7, sur les parois de l'embouchure 8 ou sous le bouchon 10, pour l'étanchéité et pour limiter les risques de casse.

Dans le cas de l'utilisation d'une force de pression F par un outil, un trou adapté est de préférence réalisé dans la surface supérieure de la première cavité 22 contenant le bouchon 10. La connexion outil de pression F / dispositif 20 est alors effectuée avec des joints classiques pour le vide (métal ou viton^{™}).

Le dispositif 20 peut être en différents matériaux appropriés. En particulier, dans le cas où la fusion du matériau fusible 16 est effectuée par laser, il peut être souhaitable de choisir comme matériau pour le dispositif 20 un matériau transparent à la longueur d'onde utilisée, par exemple une longueur d'onde dans l'infrarouge émise pour la fusion ; pour d'autres procédés de fusion du matériau 16, ou d'autres longueurs d'onde, le dispositif 20 peut également être en verre, qui peut être poli et usiné par les techniques classiques de la microélectronique, par exemple par KOH, connues de l'homme du métier. Le dispositif 20 peut également être constitué de plusieurs matériaux.

La connexion au système de remplissage peut être réalisée par un tuyau 28 en verre brasé sur le verre du dispositif 20.

Le bouchon 10 est préférentiellement réalisé dans le même matériau que l'enveloppe 3 de la cavité 5, par exemple du silicium. Dans cette hypothèse, le matériau fusible 16 peut être déposé par électrolyse, et le bouchon 10 usiné par des techniques classiques de gravure de la microélectronique.

Tel que précisé plus haut, la forme du bouchon 10 n'est qu'illustrative. Par ailleurs, l'association de matériau inerte avec le matériau fusible n'est aussi qu'un mode de réalisation préféré : il est possible de n'avoir qu'un matériau déformable plastiquement pour le bouchon 10. Une variante pour la fermeture est ainsi l'utilisation d'une bille 30 de métal mou, comme par exemple l'indium : figure 5A. Le procédé de remplissage et fermeture est le même que précédemment, mais le bouchon 30' est dans ce cas écrasé avec un outil au dessus de l'orifice 7 : voir figure 5B.

Dans ce mode de réalisation particulièrement, il est clair que selon la forme de l'orifice 7, et en présence par exemple d'une embouchure 8, il est possible d'avoir une surface externe 4 du composé électronique 1 plane après fermeture.

Pour un bon positionnement du bouchon 10 ou de la bille 30 au dessus de l'orifice 7, lorsque le dispositif 20 coulisse notamment entre plusieurs positions fonctionnelles, il est possible d'usiner la surface inférieure 24 du dispositif 20 afin de servir de guide, par exemple par un marquage adapté. Avantageusement, un déplacement précis du dispositif 20 par rapport au composé 1 à remplir peut être effectué grâce à des encoches ou butées ou rainures pour permettre un alignement du dispositif 20 avec le trou 7, 8.

L'utilisation d'une telle fermeture avec bouchon a pour avantage de permettre le vide et le remplissage d'une cavité en utilisant un orifice de dimensions potentiellement importantes (de l'ordre du mm), permettant ainsi de limiter le temps nécessaire à la mise sous vide et au remplissage de la cavité par rapport à l'usage habituel de capillaires. Par ailleurs, les contraintes mécaniques sur le composé 1 à remplir, dues à la liaison cavité 5 / pompe à vide par exemple, sont reportées sur le dispositif de fermeture 20, limitant les risques de casse au niveau du tuyau 28.

En outre, dans le cas de structures très planes, en particulier n'excédant pas quelques millimètres d'épaisseur, le procédé selon l'invention permet de réaliser le remplissage par le dessus et non par la tranche de la cavité 5, tout en conservant la planéité finale du composé 1. De même, la suppression du queusot résultant de cette méthode permet une compacité accrue de l'objet final, dans le cas du remplissage de composés miniatures.

Un tel dispositif de fermeture, ainsi que le procédé associé, sont ainsi particulièrement utiles à la réalisation de caloducs plats et miniaturisés en silicium, mais également pour tout système fluidique réalisé sur un substrat plan, dans lequel on veut introduire un fluide précis, en bannissant au maximum tout autre espèce ou gaz incondensables.

## Revendications

1. Dispositif (20) de fermeture d'un composé microélectronique (1) comprenant une cavité (5) débouchant par un orifice (7) sur une première surface (4), le dispositif (20) comprenant une deuxième surface (24) susceptible de coopérer avec la première surface (4) et un bouchon (10) adjacent à la deuxième surface (24), une partie au moins du bouchon (10) étant en matériau déformable plastiquement (16), et le bouchon (10) étant susceptible, dans son état non déformé et dans un état déformé, d'obturer l'orifice (7) du composé microélectronique (1).

2. Dispositif selon la revendication 1 comprenant une première cavité (22) ouverte sur la deuxième surface (24), dans laquelle est logé le bouchon (10).

3. Dispositif selon l'une des revendications 1 à 2 comprenant une deuxième cavité (26) traversante et ouverte, ou susceptible de s'ouvrir, sur la deuxième surface (24), localisée à une distance non nulle du bouchon (10).

4. Dispositif (20) de fermeture d'une première surface (4) d'un composé microélectronique (1), le dispositif (20) comprenant une deuxième surface (24), une première et une deuxième cavités ouvertes sur, ou susceptibles de communiquer avec, la deuxième surface (24), la deuxième cavité (26) étant traversante, **caractérisé en ce qu'**un bouchon (10) est logé dans la première cavité (22) et adjacent à la deuxième surface (24), une partie au moins du bouchon (10) étant en matériau déformable plastiquement (16).

5. Dispositif selon la revendication 3 ou 4 comprenant des moyens (28) pour connecter la deuxième cavité (26) à un système de pompage et/ou de remplissage.

6. Dispositif selon l'une des revendications 3 à 5 comprenant des moyens (29) pour mettre en communication la première (22) et la deuxième cavité (26).

7. Dispositif selon l'une des revendications 1 à 6 dans lequel le matériau déformable plastiquement est un métal mou (30).

8. Dispositif selon l'une des revendications 1 à 6 dans lequel le bouchon (10) comprend un noyau inerte (12, 14) et une partie (16) en matériau fusible.

9. Dispositif selon l'une des revendications 1 à 8 comprenant des moyens pour relier le bouchon (10) à un outil de pression.

10. Dispositif selon l'une des revendications 1 à 9 dans lequel le bouchon (110) présente sensiblement la forme d'un champignon comprenant un pied (12) et un couvercle (14) en matériau semi-conducteur, et une partie en matériau fusible (16) localisée à la surface du couvercle (14) solidarisée au pied (12), la hauteur du bouchon entre la surface du couvercle (14) opposée au pied (12) et l'extrémité du pied (12) opposée au couvercle (14) étant comprise entre 100 µm et 1 mm.

11. Système comprenant un dispositif (20) selon l'une des revendications 1 à 10 et un composé microélectronique (1) comprenant une cavité (5) débouchant par un orifice (7) sur la première surface (4), laquelle peut coulisser par rapport à la deuxième surface (24) du dispositif (20).

12. Système selon la revendication 11 dans lequel la première et la deuxième surface (4, 24) sont planes.

13. Système selon l'une des revendications 11 à 12 dans lequel la première surface (4) du composé (1) comprend un revêtement métallique (9).

14. Système selon l'une des revendications 11 à 13 dans lequel la première surface (4) comprend un dépôt de matériau fusible.

15. Système selon l'une des revendications 11 à 14 dans lequel le bouchon (10) est composé au moins partiellement du même matériau que la couche (3) du composé (1) adjacente à la première surface (4).

16. Système selon l'une des revendications 11 à 15 comprenant des moyens de guidage pour assurer le déplacement du dispositif (20) par rapport au composé (1).

17. Procédé de fermeture hermétique d'une cavité (5) d'un composé microélectronique (1) débouchant par un orifice (7), comprenant la mise en place d'un dispositif (20) selon l'une des revendications 1 à 10, sur l'orifice (7) de façon à ce que le bouchon (10) soit en place au dessus de l'orifice (7), la déformation plastique du bouchon (10) de façon à obturer hermétiquement l'orifice (7).

18. Procédé selon la revendication 17 dans lequel le bouchon (10) est conçu de façon à affleurer à la surface (4) du composé (1) après déformation plastique.

19. Procédé selon l'une des revendications 17 à 18 dans lequel la mise en place du dispositif (20) s'effectue par coulissement du dispositif (20) le long du composé microélectronique (1).

20. Procédé selon la revendication 19 comprenant la mise en place du dispositif (20) sur le composé (1), le remplissage de la cavité (5), puis le coulissement du dispositif (20).

## Claims

1. Sealing device (20) of a microelectronic component (1) comprising a cavity (5) opening via an orifice (7) onto a first surface (4), wherein the device (20) comprises a second surface (24) capable of cooperating with the first surface (4) and a cap (10) adjacent to the second surface (24), wherein at least one part of the cap (10) is a plastically deformable material (16), and the cap (10) is capable, in its non deformed state and in a deformed state, of obstructing the orifice (7) of the microelectronic component (1).

2. Device according to claim 1 comprising a first cavity (22) open on the second surface (24), in which the cap (10) is housed.

3. Device according to any of claims 1 to 2 comprising a second cavity (26) that traverses and is open, or capable of opening, onto the second surface (24), located at a distance that is not zero from the cap (10).

4. Sealing device (20) according to a first surface (4) of a microelectronic component (1), wherein the device (20) comprises a second surface (24), first and second cavities opening onto, or capable of communicating with, the second surface (24), wherein the second cavity (26) traverses, **characterised in that** a cap (10) is housed inside the first cavity (22) and adjacent to the second surface (24), wherein at least one part of the cap (10) is a plastically deformable material (16).

5. Device according to claim 3 or 4 comprising means (28) of connecting the second cavity (26) to a system for pumping and/or filling.

6. Device according to any of claims 3 to 5 comprising means (29) of bringing into communication the first (22) and the second cavity (26).

7. Device according to any of claims 1 to 6 in which the plastically deformable material is a soft metal (30).

8. Device according to any of claims 1 to 6 in which the cap (10) comprises an inert core (12, 14) and a part (16) made of meltable material.

9. Device according to any of claims 1 to 8 comprising means of connecting the cap (10) to a pressure tool.

10. Device according to any of claims 1 to 9 in which the cap (10) substantially has the shape of a mushroom comprising a base (12) and a cover (14) made of a semi-conductor material, and one part in meltable material (16) located on the surface of the cover (14) attached to the base (12), wherein the height of the cap between the surface of the cover (14) opposite the base (12) and the end of the base (12) opposite the cover (14) is between 100 µm and 1 mm.

11. System comprising a device (20) according to any of claims 1 to 10 and a microelectronic component (1) comprising a cavity (5) opening via an orifice (7) onto the first surface (4), which can slide with respect to the second surface (24) of the device (20).

12. System according to claim 11 in which the first and the second surface (4, 24) are flat.

13. System according to any of claims 11 to 12 in which the first surface (4) of the component (1) comprises a metallic coating (9).

14. System according to any of claims 11 to 13 in which the first surface (4) comprises a deposit of meltable material.

15. System according to any of claims 11 to 14 in which the cap (10) is composed at least partially of the same material as the layer (3) of the component (1) adjacent to the first surface (4).

16. System according to any of claims 11 to 15 comprising guiding means to control the movement of the device (20) with respect to the component (1).

17. Hermetic sealing process of a cavity (5) of a microelectronic component (1) opening via an orifice (7), comprising the implantation of a device (20) according to any of claims 1 to 10, on the orifice (7) so that the cap (10) is positioned above the orifice (7), and the plastic deformation of the cap (10) obstructs the orifice (7) hermetically.

18. Process according to claim 17 in which the cap (10) is designed so that it is in light contact with the surface (4) of the component (1) after plastic deformation.

19. Process according to any of claims 17 to 18 in which the device (20) is positioned by sliding it along the microelectronic component (1).

20. Process according to claim 19 comprising the positioning of the device (20) on the component (1), the filling of the cavity (5), and the sliding of the device (20).

## Patentansprüche

1. Vorrichtung (20) zum Verschließen eines mikroelektronischen Bauteils (1), das einen Hohlraum (5) umfasst, der mit einer Öffnung (7) an einer ersten Oberfläche (4) mündet, wobei die Vorrichtung (20) eine mit der ersten Oberfläche (4) kooperierende zweite Oberfläche (24) und ein an die zweite Oberfläche (24) anstoßendes Verschlusselement (10) umfasst, wobei wenigstens ein Teil des Verschlusselements (10) aus einem plastisch verformbaren Material (16) ist und das Verschlusselement (10) in seinem unverformten Zustand und in einem verformten Zustand fähig ist, die Öffnung (7) des mikroelektronischen Bauteils (1) zu verschließen.

2. Vorrichtung nach Anspruch 1 mit einem an der zweiten Oberfläche (24) offenen ersten Hohlraum (22), in dem das Verschlusselement (10) sitzt.

3. Vorrichtung nach einem der Ansprüche 1 bis 2, einen mit einem Nichtnull-Abstand von dem Verschlusselement (10) lokalisierten zweiten Hohlraum (26) umfassend, der durchgehend und an der zweiten Oberfläche (24) offen ist oder sich öffnen kann.

4. Vorrichtung (20) zum Verschließen einer ersten Oberfläche (4) eines mikroelektronischen Bauteils (1), wobei die Vorrichtung (20) eine zweite Oberfläche (24) und offene Hohlräume umfasst, einen ersten und einen zweiten, die an der zweiten Oberfläche (24) offen sind, oder kommunizierfähig, wobei der zweite Hohlraum (26) durchgehend ist,
**dadurch gekennzeichnet, dass** in dem ersten Hohlraum (22) ein an die zweite Oberfläche (24) anstoßendes Verschlusselement (10) sitzt, wobei wenigstens ein Teil des Verschlusselements (10) durch ein plastisch verformbares Material (16) gebildet wird.

5. Vorrichtung nach Anspruch 3 oder 4 mit Einrichtungen (28) zum Verbinden des zweiten Hohlraums (26) mit einem Pump- und/oder Füllsystem.

6. Vorrichtung nach einem der Ansprüche 3 bis 5 mit Einrichtungen (29) zur Herstellung der Verbindung zwischen dem ersten (22) und zweiten (26) Hohlraum.

7. Vorrichtung nach einem der Ansprüche 1 bis 6, bei der das plastisch verformbare Material (30) ein Weichmetall ist.

8. Vorrichtung nach einem der Ansprüche 1 bis 6, bei der das Verschlusselement (10) einen inerten Kern (12, 14) und einen Teil (16) aus schmelzbarem Material umfasst.

9. Vorrichtung nach einem der Ansprüche 1 bis 8 mit Einrichtungen zum Verbinden des Verschlusselements (10) mit einem Druckwerkzeug.

10. Vorrichtung nach einem der Ansprüche 1 bis 9, bei der das Verschlusselement (10) im Wesentlichen die Form eines Champignons mit einem Stiel (12) und einem Hut (14) aus Halbleitermaterial aufweist und einen Teil aus schmelzbarem Material (16) umfasst, lokalisiert an der mit dem Stiel (12) verbundenen Fläche des Huts (14), wobei die Höhe des Verschlusses zwischen der dem Stiel (12) entgegengesetzten Oberfläche des Huts (14) und dem dem Hut (14) entgegengesetzten Ende des Fußes (12) zwischen 100 µm und 1 mm enthalten ist.

11. System mit einer Vorrichtung (20) nach einem der Ansprüche 1 bis 10 und einem mikroelektronischen Bauteil (1), das einen Hohlraum (5) umfasst, der durch eine Öffnung (7) an der ersten Oberfläche (4) mündet, die verschiebbar ist in Bezug auf die zweite Oberfläche (24) der Vorrichtung (20).

12. System nach Anspruch 11, bei dem die erste und die zweite Oberfläche (4, 24) plan sind.

13. System nach einem der Ansprüche 11 bis 12, bei dem die erste Oberfläche (4) des Bauteils (1) eine metallische Beschichtung (9) aufweist.

14. System nach einem der Ansprüche 11 bis 13, bei dem die erste Oberfläche (4) eine Abscheidung aus schmelzbarem Material umfasst.

15. System nach einem der Ansprüche 11 bis 14, bei dem das Verschlusselement (10) wenigstens teilweise aus dem gleichen Material ist wie die Schicht (3) des an die erste Oberfläche (4) anstoßenden Bauteils (1).

16. System nach einem der Ansprüche 11 bis 15 mit Einrichtungen zur Führung der Verschiebung der Vorrichtung (20) in Bezug auf das Bauteil (1).

17. Verfahren zum hermetischen Verschließen eines durch eine Öffnung (7) mündenden Hohlraums (5) eines mikroelektronischen Bauteils (1), umfassend die Platzierung einer Vorrichtung (20) nach einem der Ansprüche 1 bis 10 auf der Öffnung (7), derartig, dass das Verschlusselement (10) sich über der Öffnung (7) befindet, so dass die plastische Verformung des Verschlusselements (10) die Öffnung (7) hermetisch verschließt.

18. Verfahren nach Anspruch 17, bei dem das Verschlusselement (10) so konzipiert ist, dass es nach der plastischen Verformung mit der Oberfläche (4) des Bauteils (1) bündig abschließt bzw. eine Ebene bildet.

19. Verfahren nach einem der Ansprüche 17 bis 18, bei dem die Platzierung der Vorrichtung (20) durch Verschiebung der Vorrichtung (20) längs des mikroelektronischen Bauteils (1) erfolgt.

20. Verfahren nach Anspruch 19, umfassend die Platzierung der Vorrichtung (20) auf dem Bauteil (1), das Füllen des Hohlraums (5), dann die Verschiebung der Vorrichtung (20).
